# FASCICULE DE BREVET EUROPEEN

(11) **EP 1 774 372 B1**
(45) Date de publication et mention de la délivrance du brevet: **20.07.2011**
(21) Numéro de dépôt: 05762653.3
(22) Date de dépôt: 04.05.2005
(51) Int. Cl.: G02B 5/04, H01L 31/00, H01L 25/00, B29C 43/00

(54) **FEUILLE TRANSPARENTE TEXTUREE A MOTIFS PYRAMIDAUX QUI PEUT ÊTRE ASSOCIÉE À DES CELLULES PHOTOVOLTAIQUES**
TEXTURIERTER TRANSPARENTER FILM MIT PYRAMIDENMUSTERN, DIE MIT PHOTOVOLTAISCHEN ZELLEN ASSOZIIERT WERDEN KÖNNEN
TEXTURED TRANSPARENT FILM HAVING PYRAMIDAL PATTERNS THAT CAN BE ASSOCIATED WITH PHOTOVOLTAIC CELLS

(30) Priorité: 10.05.2004 FR 0450892
(43) Date de publication de la demande: 18.04.2007
(73) Titulaire: SAINT-GOBAIN GLASS FRANCE, 92400 Courbevoie (FR)
(72) Inventeur: GAYOUT, Patrick, F-93250 VILLEMOMBLE (FR); NEUMANN, Dirk, 52134 Herzogenrath (DE); VAVERKA, Ingrid, 52074 AACHEN (DE); BLIESKE, Ulf, 68535 Edingen-Neckerhausen (DE)
(74) Mandataire: Colombier, Christian
(86) Numéro de dépôt international: PCT/FR2005/050304
(87) Numéro de publication internationale: WO 2005/111670

(56) Documents cités:
- WO-A-99/44954
- WO-A-03/046617
- WO-A1-00/07793
- GB-A- 878 215
- GB-A- 1 590 116
- US-A- 4 998 188
- US-A1- 2002 163 728
- PATENT ABSTRACTS OF JAPAN vol. 1996, no. 06, 28 juin 1996 (1996-06-28) & JP 08 048951 A (SEKISUI CHEM CO LTD), 20 février 1996 (1996-02-20)

## Description

L'invention concerne un procédé de fabrication d'une feuille texturée par des motifs géométriques incrustés.

Le WO 03046617 enseigne la réalisation et l'utilisation de plaques texturées pour améliorer la transmission lumineuse de plaques transparente intégrées dans des cellules photovoltaïques, lampes plane à décharge plasma, écrans LCD, collecteurs solaires, projecteurs d'image. Les motifs de la texture peuvent notamment être concaves par rapport au plan général de la face texturée de la plaque, c'est-à-dire incrustés dans la plaque de base. Ces motifs peuvent notamment être réalisés par laminage à chaud d'une feuille exempte de motifs par un rouleau imprimant les motifs souhaités à la plaque. Suivant la nature des motifs, ceux-ci peuvent se laisser réaliser plus ou moins facilement. En particulier, on peut parfois observer une tendance de la matière à l'état pâteux à adhérer au rouleau de laminage, ce qui génère des défauts visibles à l'oeil nu. Les motifs ne sont alors pas correctement réalisés, et de plus, la feuille a tendance à s'enrouler autour du rouleau de laminage. Lorsque cela arrive, il est nécessaire d'arrêter la fabrication. On peut combattre cet effet de collage en abaissant la vitesse de production. Par ailleurs, lorsque les motifs incrustés de la plaque texturée sont en contact avec l'air ambiant dans l'utilisation finale, ceux-ci ont tendance à se remplir de poussières ou salissures et à se laisser nettoyer plus ou moins facilement. C'est notamment le cas si l'on utilise la plaque texturée pour protéger une cellule photovoltaïque placée à l'extérieur. Le document GB878215 divulgue un procédé de fabrication d'une plaque transparente texturée comprenant une étape de moulage.

L'invention apporte une solution aux problèmes sus-mentionnés. L'invention concerne un procédé tel que revendiqué dans la revendication 1 pour la fabrication d'une plaque transparent en verre minéral comprenant au moins deux bords principaux parallèles, et comprenant en relief sur au moins l'une de ses surfaces principales des motifs pyramidaux (concaves ou convexes) répétitifs en relief comprenant chacun un sommet, une base et un ensemble d'arêtes joignant le sommet à la base, au moins une arête desdits motifs étant telle que sa projection dans le plan général de la plaque est sensiblement parallèle audits deux bords principaux parallèles. On utilise ici le mot arête pour désigner l'une des arêtes de la pyramide joignant le sommet et la base. Le terme arête ne désigne donc pas l'un des côtés de la base de la pyramide.

La demanderesse a observé que la disposition judicieuse d'au moins une arête comme il vient d'être dit, était avantageuse. En effet, l'arête est avantageusement dans le sens du laminage, lequel est parallèle à au moins deux bords principaux, car les motifs sur le rouleau de laminage semblent ainsi plus facilement rentrer en contact avec la plaque à l'état pâteux et s'en séparer sans endommager l'empreinte qui vient d'être faite. En tout cas, la demanderesse a observé que ces conditions étaient plus favorables (moins de défauts géométriques visibles à l'oeil nu) en comparaison avec des motifs dont toutes les arêtes sont en biais par rapport au sens de laminage. Il semble que l'angle que fait
- la droite située à l'intersection d'une part d'un plan perpendiculaire au plan général de la plaque et passant par le sommet de la pyramide et d'autre part de la pyramide elle-même,
   avec
- le plan général de la plaque,
   soit particulièrement important pour la qualité de formage des motifs en relief. Il semble en effet qu'il soit préférable que cet angle soit faible, car ainsi l'interpénétration du rouleau de laminage et de la plaque paraît se faire de façon plus progressive. Il semble qu'au niveau de chaque motif, la pyramide mâle (pouvant suivant le cas se trouver sur le rouleau de laminage ou sur la plaque à texturer) et la pyramide femelle correspondante se séparent de façon plus douce et avec une plus faible tendance à coller l'une à l'autre. Cet effet est observé à la fois pour la réalisation de pyramides concaves ou convexes sur la plaque texturée. Ce meilleur comportement à l'impression du motif permet d'augmenter les vitesses de fabrication.

Dans le cas de la réalisation de pyramides concaves sur la plaque texturée (par un rouleau de laminage comprenant des pyramides convexes), un effet supplémentaire a été observé. En effet, comme la plaque est placée en utilisation finale de façon à ce que les deux bords principaux apparaissent verticaux quand on regarde la plaque de face (le plan général de la plaque étant incliné, par exemple à 45° par rapport à l'horizontale), l'arête judicieusement placée apparaît également verticale vue de face et peut jouer le rôle de gouttière d'évacuation pour les salissures, poussières et tout liquide, notamment de nettoyage, ayant pénétré volontairement ou involontairement dans le motif, et ce sans qu'il ne soit nécessaire de bouger ou démonter la plaque. De ce fait, une plaque munie de pyramides concaves s'encrasse moins au cours du temps si ses motifs sont orientés conformément à l'invention.

Ainsi, on peut utiliser une plaque transparente comprenant des motifs pyramidaux concaves (c'est-à-dire incrustés) ou convexes répétitifs comprenant chacun un ensemble d'arêtes, dont au moins une arête des motifs apparaît verticale lorsque la plaque est regardée de face et dans la moitié inférieure du motif. L'arête est un segment joignant le centre du motif (ou sommet de la pyramide) et la périphérie du même motif (ou base de la pyramide), ladite périphérie se trouvant dans le plan général de la plaque. Lorsque la plaque est munie de pyramides concaves, l'arête judicieusement placée des motifs se trouve dans leur partie inférieure et joue un rôle gouttière d'évacuation pour les salissures et autres agents étrangers coulant sur ladite arête sous l'effet de leur poids. Cet effet est obtenu dès lors que le plan général de la plaque est suffisamment incliné par rapport à l'horizontale.

La plaque est généralement inclinée avec un angle allant de 10 à 90° et plus généralement 20 à 70° par rapport à l'horizontale. Cette inclinaison représente un choix pouvant dépendre des conditions locales d'ensoleillement. Selon le procédé de l'invention, une plaque vierge de tout motif est portée à sa température de ramollissement et soumise à l'action d'un rouleau de laminage. De préférence, le rouleau de laminage est animé à l'endroit de la formation des pyramides d'une vitesse linéaire inférieure à celle du verre en zone de refroidissement. Le rouleau comprend à sa surface les motifs à imprimer dans la plaque. Ces motifs apparaissent convexes sur le rouleau si l'on cherche à produire des motifs concaves dans la plaque, et vice versa. Ce procédé est applicable aux plaques en verre minéral et aux polymères thermoplastiques tel qu'un polyuréthane ou un polycarbonate ou un polyméthacrylate de méthyle. L'invention concerne donc un procédé de fabrication d'une plaque par laminage à sa température de déformation d'une plaque exempte desdits motifs à l'aide d'un rouleau imprimant la texture à la plaque, le sens du laminage étant parallèle audits deux bords principaux et à au moins une arête desdits motifs.

Dans le cas d'une plaque en verre minéral à base de silice, la texturation de la plaque peut également être réalisée lors d'une éventuelle étape de trempe thermique, juste avant que le verre ne se fige.

De préférence, l'essentiel de la masse (c'est-à-dire pour au moins 98 % en masse), voire la totalité de la plaque est constituée de matériau(x) présentant la meilleure transparence possible et ayant de préférence une absorption linéique inférieure à 0,01 mm⁻¹ dans la partie du spectre utile à l'application, généralement le spectre allant de 380 à 1200 nm.

Les motifs rejoignent le plan général de la face texturée de la plaque par une base, ladite base pouvant s'inscrire à l'intérieur d'un cercle dont le diamètre est généralement inférieur à 10 mm, voire inférieur à 7 mm. De préférence, le plus petit cercle pouvant contenir la base de l'un desdits motifs présente un diamètre d'au maximum 5 mm, notamment allant de 0,001 mm à 5 mm, par exemple allant de 1 à 5 mm.

De préférence, les motifs sont jointifs. Des motifs sont dits jointifs lorsqu'ils se touchent en au moins une partie de leur base (à la surface et dans le plan général de la plaque).

Les motifs ont la forme de pyramide à base polygonale comme triangulaire ou carrée ou rectangulaire ou hexagonale ou octogonale, et sont concaves (venant en creux dans la masse de la plaque) ou convexes. Les pyramides ont généralement un axe de symétrie passant par leur sommet. De préférence, la pyramide a deux de ses arêtes telles que leur projection dans le plan général de la plaque est sensiblement parallèle aux deux bords principaux parallèles de la plaque. C'est notamment le cas lorsque la pyramide a un axe de symétrie passant par son sommet et perpendiculaire au plan général de la plaque. Ces deux arrêtes apparaissent dans le prolongement l'une de l'autre pour traverser toute la pyramide pour un observateur regardant la pyramide avec une direction de vision perpendiculaire à la plaque.

De préférence, la pyramide présente quatre côtés (ou faces) et quatre arêtes. Dans ce cas, elle est orientée dans la plaque de sorte que deux de ses arêtes apparaissent verticales et formant à elles deux une ligne diagonale de la pyramide pour un observateur regardant la plaque en face (vision horizontale). Ces deux arêtes apparaissent dans le prolongement l'une de l'autre pour un observateur regardant la plaque en face, l'une des arêtes étant dans la partie inférieure, l'autre arête étant dans la partie supérieure de la pyramide.

On préfère que tout demi-angle au sommet de ladite pyramide soit inférieur à 70°, et de préférence soit inférieur ou égal à 60°, par exemple aille de 25 à 60°. Un demi-angle au sommet est un angle entre l'axe de symétrie de la pyramide et une droite contenue dans la surface de la pyramide et passant par le sommet. Une pyramide contient une multitude de demi-angles au sommet car les angles entre deux arêtes en vis-à-vis sont plus importants que les angles entre deux côtés en vis-à-vis.

La plaque texturée peut notamment servir à améliorer la capture de la lumière du soleil pour augmenter le flux lumineux alimentant des cellules photo-électriques. La plaque selon l'invention capture même les rayons lumineux très rasants (faible angle d'incidence). Ces cellules photo-électriques peuvent être encapsulées dans une résine du type polyvinylbutyral (PVB) ou copolymère éthylène-acétate de vinyle (EVA). Cette encapsulation est réalisée de manière connue en autoclave sous pression à chaud (fusion de la résine) ce qui mène à une feuille de résine dans laquelle les cellules sont emprisonnées. La plaque texturée est alors juxtaposée à cette feuille pour capter la lumière (texture du côté de l'air ambiant) et la délivrer aux cellules dans la feuille. De l'autre côté de la feuille contenant les cellules peut se trouver une plaque de verre. Il est possible d'associer tous ces composants en une seule étape en autoclave. Une telle structure complexe peut servir à la fois de capteur d'énergie solaire et de mur anti-bruit. Son efficacité anti-bruit est d'autant meilleure que la résine utilisée est du type « acoustique », c'est-à-dire atténue le bruit.

Ainsi, l'invention concerne également un procédé de fabrication d'un ensemble comprenant une plaque et au moins une cellule photo-électrique selon la revendication 7, la texture de la plaque étant en contact avec l'air ambiant (c'est-à-dire dirigée vers l'extérieur), la plaque et la cellule étant disposées parallèlement entre elles. Notamment, la cellule photo-électrique peut être encapsulées dans une résine, laquelle peut être un PVB. Ce PVB peut de plus atténuer les bruits.

On peut réaliser un dispositif de conversion de l'énergie lumineuse en énergie électrique par au moins une cellule photoélectrique, comprenant un ensemble plaque/cellule photo-électrique, au moins une arête des motifs apparaissant verticale lorsque la plaque est regardée de face et dans la moitié inférieure du motif, ladite texture se trouvant du côté de la lumière incidente, ladite plaque étant inclinée par rapport à l'horizontale selon un angle allant de 10 à 90°.

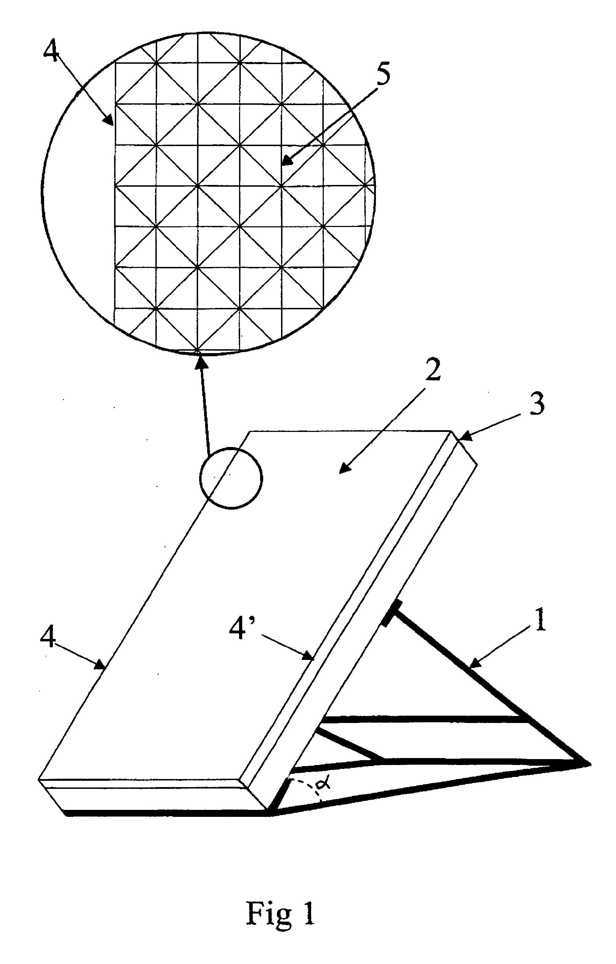

La figure 1 représente un ensemble de transformation de la lumière naturelle solaire en énergie électrique. Un bâti métallique 1 maintient en position inclinée d'un angle alpha par rapport à l'horizontale, un ensemble de réception de la lumière comprenant une plaque texturée 2 en verre minéral transparent posée sur un plan de cellules photovoltaïques 3. La plaque texturée comprend deux bords parallèles 4 et 4'. Pour un observateur regardant l'ensemble de face, ces deux bords 4 et 4' apparaissent verticaux. La plaque texturée augmente l'intensité lumineuse transmise aux cellules en comparaison avec une plaque transparente identique mais dénuée de toute texture. L'énergie électrique fournie est donc plus forte du fait de la présence de la texture. Le relief de cette texture se trouve du côté de l'air ambiant, c'est-à-dire du côté de réception de la lumière. Les motifs sont jointifs et sont ici une succession de motifs répétitifs pyramidaux concaves (ou incrustés dans la plaque). Chaque pyramide comprend quatre côtés et quatre arêtes se rejoignant en un sommet. Ces pyramides sont orientées en biais par rapport aux bords 4 et 4' de la plaque (les côtés de la base forment un angle de 45° avec les bords 4 et 4'). Grâce à cette orientation, au moins une arête de chaque pyramide apparaît verticalement pour un observateur regardant l'ensemble de face et se trouve dans la moitié inférieure de la pyramide (ici concave). Grâce à cette situation, cette arête peut jouer le rôle de gouttière d'évacuation pour tout corps étranger se trouvant dans la pyramide.

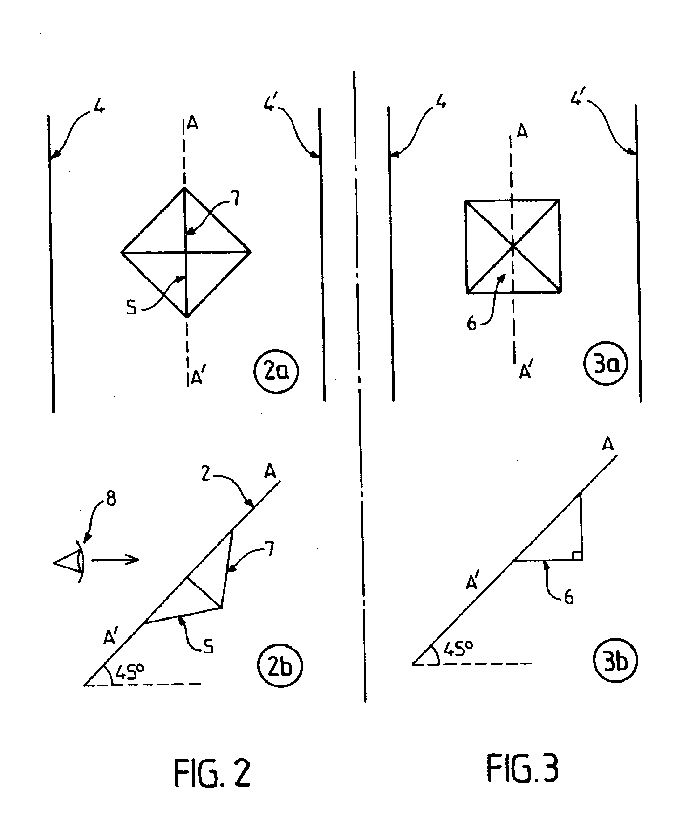

Les figures 2 et 3 fournissent à titre indicatif une explication à l'effet gouttière conférée par l'arête 5 au motif concave. La figure 2a représente un motif pyramidal concave orienté conformément à l'invention, c'est-à-dire de sorte qu'une arête 5 apparaisse verticale pour un observateur regardant la plaque de face et soit parallèle aux deux bords principaux 4 et 4' de la plaque. La figure 2b représente le motif de la figure 2a vu en coupe selon AA', dans la plaque 2 inclinée à 45° par rapport à l'horizontale. La ligne AA' de la figure 2b est dans le plan général de la plaque, les motifs étant réalisés en creux par rapport à ce plan. On remarque que l'arête 5 est bien inclinée vers le bas dans le sens d'une évacuation aisée de tout corps étranger présent dans la pyramide. Elle est située dans la partie inférieure de la pyramide. Du fait de la géométrie de la pyramide, une autre arête 7 se trouvant dans la partie supérieure du motif se trouve dans le prolongement de l'arête 5, de sorte que pour un observateur regardant la plaque en face (vision horizontale représentée par l'oeil 8) les arêtes 5 et 7 sont dans le prolongement l'une de l'autre et apparaissent former une ligne verticale comme sur la figure 2a. La projection de l'arête 5 dans le plan général de la plaque se trouve dans la ligne AA' de la figure 2b et cette projection est parallèle aux deux bords principaux parallèles 4 et 4'. A titre comparatif, la figure 3 représente exactement la même pyramide sauf qu'elle n'est pas orientée en biais par rapport au sens général de la plaque. Ici, aucune arête n'apparaît verticale pour un observateur regardant la plaque de face. Aucune arête n'apparaît parallèle aux bords 4 et 4' pour un observateur de face. Un corps étranger dans la pyramide doit être évacué en glissant sur le côté inférieur 6. Cependant, la vue en coupe selon le plan vertical AA' (figure 3b) montre que le côté 6 est bien moins incliné (il est même sensiblement horizontal) que l'arête 5 dans le cas de la figure 2. C'est pourquoi la configuration « pyramide en biais » (par rapport aux bords 4 et 4' de la plaque) et selon l'invention de la figure 2 est plus favorable à l'évacuation des corps étrangers dans la pyramide que la configuration de la figure 3. Cette configuration est plus favorable à l'écoulement des eaux de pluie et au nettoyage de la plaque. Cette configuration est également plus favorable à la fabrication de la plaque par laminage, peut-être du fait d'une analogie de comportement entre un écoulement d'un liquide à l'intérieur du motif et le déplacement de l'empreinte solide dans la pyramide au cours de la fabrication. On voit que l'angle que fait
   - la droite située à l'intersection d'une part d'un plan perpendiculaire au plan général de la plaque et passant par le sommet de la pyramide et d'autre part de la pyramide elle-même,
avec
   - le plan général de la plaque,
   est l'angle entre l'arête 5 (ou 6 pour la figure 3b) et le plan général de la plaque se confondant sur les figures 2b et 3b avec la ligne AA'. Cet angle est notablement inférieur dans le cas d'une orientation de la pyramide selon l'invention (comparer 5 de la fig 2b avec 6 de la fig 3b). Cet angle plus faible est favorable pour la qualité de formage des motifs en relief.

Bien entendu, les bords 4 et 4' ont été représentés de façon à indiquer leur orientation, mais la distance entre 4 et 4' est bien plus importante qu'il ne paraît avec les figures 2a et 3a (relativement à la taille du motif dessiné), puisque entre ces bords se trouvent une multitude de motifs (généralement plusieurs dizaines de motifs).

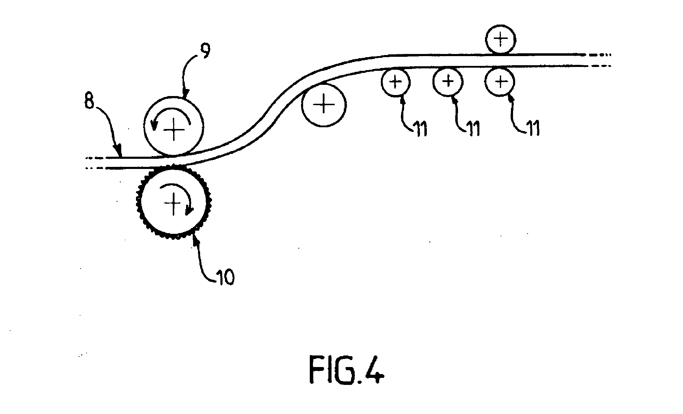

La figure 4 montre un procédé de fabrication selon l'invention. Tout ce qui est visible sur cette figure est dans un four (non représenté) à 1000°C. Le verre plat 8 à l'état pâteux est calandré entre deux rouleaux 9 et 10, ce dernier (10) présentant à sa surface des pyramides convexes. Le verre étant pressé entre ces deux rouleaux, il se forme une texture de pyramides concaves sur sa face inférieure. Le verre est ensuite amené sur un lit de rouleaux 11 et subit ensuite un refroidissement. La vitesse du ruban de verre est de 3 m / minute. La vitesse linéaire du rouleau 10 de texturation est environ 20% plus faible que celle du ruban de verre, c'est-à-dire est d'environ 2,4 m/minute. La vitesse linéaire de tous les autres rouleaux est identique à la vitesse du ruban. Le ruban est en fait tiré de l'extérieur du four par d'autres rouleaux.

A titre d'exemple, dans le cas d'une fabrication correspondant à celle de la figure 4, les pyramides étant à base carrée 2,4x2,4 mm et d'une profondeur de 1,1 mm, on a constaté qu'une orientation des pyramides conformément à l'invention (comme sur la figure 2) permettait un rendement de 80% alors que lorsque les pyramides sont orientées comme sur la figure 3, le rendement n'est que de 30%. Ce rendement est le rendement de fabrication. En effet la malformation des pyramides se traduit également par le fait que le ruban de verre, au lieu de suivre son chemin normal en direction des rouleaux 11, a tendance à s'enrouler autour du rouleau 10, ce qui oblige à l'arrêt de la production.

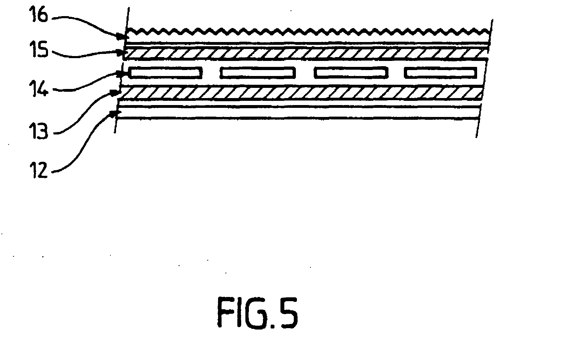

La figure 5 montre un empilement de feuilles et plaques avant passage en autoclave. La plaque 12 est en verre sans texture du type Planilux, sur laquelle est placée une première feuille de PVB. Les cellules photo-électriques 14 se trouve placées entre les deux feuilles de PVB 13 et 15. Tout au-dessus se trouve la plaque en verre minéral texturée selon l'invention dont la texture est se trouve du côté de l'air ambiant. Le passage en autoclave va créer l'encapsulation des cellules dans le PVB et l'adhésion entre le PVB et les plaques de verre.

Selon une variante de l'invention, il peut être judicieux de fonctionnaliser les motifs de la plaque.

On dépose ainsi à la surface des couches minces destinées à leur conférer une propriété particulière, comme par exemple celle qui consiste à permettre au substrat de rester le plus propre possible, quelles que soient les agressions environnementales, c'est-à-dire visant la permanence dans le temps des propriétés d'aspect et de surface, et permettant notamment d'espacer les nettoyages, en parvenant à éliminer au fur et à mesure les salissures se déposant progressivement à la surface du substrat, notamment les salissures d'origine organique comme les traces de doigts ou des produits organiques volatils présents dans l'atmosphère, ou même des salissures du type suie, poussières de pollution.

Or, on sait qu'il existe certains matériaux semi-conducteurs, à base d'oxyde métallique, qui sont aptes, sous l'effet d'un rayonnement de longueur d'onde adéquate, à initier des réactions radicalaires provoquant l'oxydation de produits organiques: on parle en général de matériaux « photo-catalytiques » ou encore « photo-réactifs ».

On connaît, dans le domaine des substrats à fonction de vitrage, l'utilisation de revêtements photo-catalytiques sur substrat, qui présentent un effet « anti-salissures » marqué et que l'on puisse fabriquer de manière industrielle. Ces revêtements photo-catalytiques comportent généralement de l'oxyde de titane au moins partiellement cristallisé, incorporé audit revêtement sous forme de particules, notamment de taille comprise entre quelques nanomètres (3 ou 4) et 100 nm, préférentiellement voisin de 50 nm pour l'essentiel cristallisées sous forme anatase ou anatase/rutile.

L'oxyde de titane fait en effet partie des semi-conducteurs qui, sous l'action de la lumière dans le domaine visible ou des ultraviolets, dégradent des produits organiques qui se déposent à leur surface.

Ainsi selon un premier exemple de réalisation, le revêtement à propriété photo-catalytique résulte d'une solution à base de nanoparticules de TiO₂ et d'un liant de silice (SiO₂) mésoporeuse.

Selon un deuxième exemple de réalisation, le revêtement à propriété photo-catalytique résulte d'une solution à base de nanoparticules de TiO₂ et d'un liant de silice (SiO₂) non structuré.

Quelle que la forme de réalisation du revêtement photo-calytique, au niveau des particules d'oxyde de titane, le choix s'est porté, en outre, sur de l'oxyde de titane qui est au moins partiellement cristallisé parce qu'il a été montré qu'il était beaucoup plus performant en termes de propriété photo-catalytique que l'oxyde de titane amorphe. De préférence, il est cristallisé sous forme anatase, sous forme rutile ou sous forme d'un mélange d'anatase et de rutile.

La fabrication du revêtement est opérée de manière à ce que l'oxyde de titane cristallisé qu'il contient se trouve sous forme de « cristallites », c'est-à-dire de monocristaux, ayant une taille moyenne comprise entre 0,5 et 100 nm, de préférence 3 à 60 nm. C'est en effet dans cette gamme de dimension que l'oxyde de titane paraît avoir un effet photo-catalytique optimal, vraisemblablement parce que les cristallites de cette taille développent une surface active importante.

Le revêtement à propriété photo-catalytique peut comporter également, outre l'oxyde de titane, au moins un autre type de matériau minéral, notamment sous forme d'un oxyde amorphe ou partiellement cristallisé, par exemple en oxyde de silicium (ou mélange d'oxydes), de titane, d'étain, de zirconium ou d'aluminium. Ce matériau minéral peut aussi participer à l'effet photo-catalytique de l'oxyde de titane cristallisé, en présentant lui-même un certain effet photo-catalytique, même faible par rapport à celui du TiO₂ cristallisé, ce qui est le cas de l'oxyde de titane amorphe ou partiellement cristallisé.

On peut aussi augmenter le nombre de porteurs de charge par dopage du réseau cristallin de l'oxyde de titane, en y insérant au moins un des éléments métalliques suivants: niobium, tantale, fer, bismuth, cobalt, nickel, cuivre, ruthénium, cérium, molybdène.

Ce dopage peut aussi se faire par un dopage de surface seulement de l'oxyde de titane ou de l'ensemble du revêtement, dopage de surface réalisé en recouvrant au moins une partie du revêtement d'une couche d'oxydes ou de sels métalliques, le métal étant choisi parmi le fer, le cuivre, le ruthénium, le cérium, le molybdène, le vanadium et le bismuth.

Enfin, on peut amplifier le phénomène photo-catalytique en augmentant rendement et/ou cinétique des réactions photo-catalytiques, en recouvrant l'oxyde de titane ou au moins une partie du revêtement qui l'incorpore par un métal noble sous forme de couche mince du type platine, rhodium, argent.

Le revêtement à propriété photo-catalytique présente également une surface extérieure à caractère hydrophile et/ou oléophile prononcé, notamment dans le cas où le liant est minéral, ce qui amène deux avantages non négligeables : un caractère hydrophile permet un mouillage parfait de l'eau qui peut se déposer sur le revêtement, facilitant ainsi le nettoyage. Conjointement à un caractère hydrophile, il peut aussi présenter un caractère oléophile, permettant le « mouillage » des salissures organiques qui, comme pour l'eau, tendent alors à se déposer sur le revêtement sous forme d'un film continu moins visible que des « taches » bien localisées. On obtient ainsi un effet « anti-salissures organiques » qui s'opère en deux temps: dès qu'elle se dépose sur le revêtement, la salissure est déjà peu visible. Ensuite, progressivement, elle disparaît par dégradation radicalaire amorcée par photo-catalyse.

L'épaisseur du revêtement selon l'invention est variable, elle est comprise entre quelques nanomètres et quelques micromètres, typiquement comprise 50 nm et 10 µm.

En fait, le choix de l'épaisseur peut dépendre de différents paramètres, notamment de l'application envisagée du substrat, ou encore de la taille des cristallites de TiO₂ dans le revêtement. Le revêtement peut également être choisi de surface plus ou moins lisse: une faible rugosité de surface peut en effet être avantageuse, si elle permet de développer une surface photo-catalytique active plus grande. Cependant, trop prononcée, elle peut être pénalisante en favorisant l'incrustation, l'accumulation des salissures.

## Revendications

1. Procédé de fabrication d'une plaque transparente (2) en verre minéral comprenant au moins deux bords principaux (4, 4') parallèles, et comprenant en relief sur au moins l'une de ses surfaces principales des motifs pyramidaux répétitifs en relief comprenant chacun un sommet, une base et un ensemble d'arêtes joignant le sommet à la base, **caractérisé en ce qu'**au moins une arête (5, 7) de chacun desdits motifs pyramidaux est telle que sa projection dans le plan général de la plaque est sensiblement parallèle auxdits deux bords principaux (4, 4') parallèles et **en ce que** le procédé comprend une étape de laminage, à sa température de déformation, d'une plaque exempte desdits motifs à l'aide d'un rouleau imprimant la texture à la plaque, le sens du laminage étant parallèle auxdits deux bords principaux (4, 4') parallèles et à ladite arête de chacun desdits motifs.

2. Procédé selon la revendication 1, **caractérisé en ce que** les motifs sur la plaque (2) sont concaves.

3. Procédé selon la revendication 1, **caractérisé en ce que** les motifs sur la plaque (2) sont convexes.

4. Procédé selon l'une des revendications 1 à 3, **caractérisé en ce que** la base des pyramides peut s'inscrire à l'intérieur d'un cercle dont le diamètre est inférieur à 10 mm.

5. Procédé selon l'une des revendications 1 à 4, **caractérisé en ce que** les pyramides ont quatre faces.

6. Procédé selon l'une des revendications 1 à 5, **caractérisé en ce que** les motifs sont revêtus d'une couche à propriétés photo catalytiques.

7. Procédé de fabrication d'un ensemble comprenant :
- une plaque transparente (2) comprenant au moins deux bords principaux (4, 4') parallèles, et comprenant en relief sur au moins l'une de ses surfaces principales des motifs pyramidaux répétitifs en relief comprenant chacun un sommet, une base et un ensemble d'arêtes joignant le sommet à la base, et
- au moins une cellule photo-électrique,
la plaque et la cellule photo-électrique étant disposées parallèlement entre elles, la texture de la plaque se trouvant du côté de la lumière incidente, dans lequel la plaque est fabriquée selon le procédé
de l'une des revendications 1 à 6.

8. Procédé selon la revendication 7, **caractérisé en ce que** la cellule photo-électrique est encapsulée dans une résine.

9. Procédé selon la revendication 8, **caractérisé en ce que** la résine est un PVB.

## Claims

1. Process for manufacturing a transparent plate (2) made of mineral glass and comprising at least two parallel main borders (4, 4') and having, in relief on at least one of its main surfaces, repetitive pyramidal relief features, each comprising an apex, a base and a set of edges that join the apex to the base, **characterized in that** at least one edge (5, 7) of each of said pyramidal features is such that its projection in the general plane of the plate is substantially parallel to said two parallel main borders (4, 4') and **in that** the process comprises a step of rolling, at its deformation temperature, a plate devoid of said features using a roll that impresses the texture on the plate, the rolling direction being parallel to said two parallel main borders (4, 4') and said edge of each of said features.

2. Process according to Claim 1, **characterized in that** the features on the plate are concave.

3. Process according to Claim 1, **characterized in that** the features on the plate are convex.

4. Process according to one of Claims 1 to 3, **characterized in that** the base of the pyramids may
be inscribed within a circle whose diameter is less than 10 mm.

5. Process according to one of Claims 1' to 4, **characterized in that** the pyramids have four faces.

6. Process according to one of Claims 1 to 5, **characterized in that** the features are coated with a coating having photocatalytic properties.

7. Process for manufacturing an assembly comprising:
- a transparent plate (2) comprising at least two parallel main borders (4' 4') and having, in relief on at least one of its main surfaces, repetitive pyramidal relief features, each comprising an apex, a base and a set of edges that join the apex to the base, and
- at least one photoelectric cell,
the plate and the cell being placed parallel to each other, the texture of the plate being on the side facing the incident light, in which the plate is manufactured according to the process of one of Claims 1 to 6.

8. Process according to Claim 7, **characterized in that** the photoelectric cell is encapsulated in a resin.

9. Process according to Claim 8, **characterized in that** the resin is a PVB.

## Patentansprüche

1. Verfahren zur Herstellung einer transparenten Mineralglasplatte (2), die wenigstens zwei parallele Hauptkanten (4, 4`) aufweist und die hervortretend auf wenigstens einer ihrer Hauptflächen sich wiederholende erhabene Pyramidenmuster mit jeweils einer Spitze, einer Grundfläche und einer Menge von die Spitze mit der Grundfläche verbindenden Kanten umfasst, **dadurch gekennzeichnet, dass** wenigstens eine Kante (5, 7) eines jeden der Pyramidenmuster derart ist, dass ihre Projektion in der Gesamtebene der Platte zu den beiden parallelen Hauptkanten (4, 4') im Wesentlichen parallel ist und dass das Verfahren einen Schritt zum Walzen einer musterlosen Platte, bei ihrer Verformungstemperatur, mit Hilfe einer Walze, die der Platte die Struktur aufdruckt, umfasst, wobei die Walzrichtung zu den beiden parallelen Hauptkanten (4, 4') und zu der Kante eines jeden der Muster parallel verläuft.

2. Verfahren nach Anspruch 1, **dadurch gekennzeichnet, dass** die Muster auf der Platte (2) konkav sind.

3. Verfahren nach Anspruch 1, **dadurch gekennzeichnet, dass** die Muster auf der Platte (2) konvex sind.

4. Verfahren nach einem der Ansprüche 1 bis 3, **dadurch gekennzeichnet, dass** die Grundfläche der Pyramiden einem Kreis einbeschrieben werden kann, dessen Durchmesser kleiner als 10 mm ist.

5. Verfahren nach einem der Ansprüche 1 bis 4, **dadurch gekennzeichnet, dass** die Pyramiden vier Seiten aufweisen.

6. Verfahren nach einem der Ansprüche 1 bis 5, **dadurch gekennzeichnet, dass** die Muster mit einer Schicht mit photokatalytischen Eigenschaften überzogen sind.

7. Verfahren zur Herstellung einer Anordnung umfassend:
- eine transparente Platte (2), die wenigstens zwei parallele Hauptkanten (4, 4`) aufweist und die hervortretend auf wenigstens einer ihrer Hauptflächen sich wiederholende erhabene Pyramidenmuster mit jeweils einer Spitze, einer Grundfläche und einer Menge von die Spitze mit der Grundfläche verbindenden Kanten umfasst, sowie
- wenigstens eine photoelektrische Zelle,
wobei die Platte und die photoelektrische Zelle parallel zueinander angeordnet sind, wobei die Struktur der Platte sich auf der Seite des einfallenden Lichts befindet, wobei die Platte nach dem Verfahren von einem der Ansprüche 1 bis 6 hergestellt ist.

8. Verfahren nach Anspruch 7, **dadurch gekennzeichnet, dass** die photoelektrische Zelle in ein Harz eingekapselt ist.

9. Verfahren nach Anspruch 8, **dadurch gekennzeichnet, dass** das Harz ein PVB ist.
